# EUROPEAN PATENT SPECIFICATION

(11) **EP 1 254 938 B1**
(45) Date of publication and mention of the grant of the patent: **15.09.2004**
(21) Application number: 02009482.7
(22) Date of filing: 25.04.2002
(51) Int. Cl.: C09J 7/02, H01L 21/00

(54) **Method for thermally releasing adherend and apparatus for thermally releasing adherend**
Verfahren zur thermischen Ablösung einer Klebefläche und Vorrichtung zur thermischen Ablösung einer Klebefläche
Procédé pour détacher thermiquement une surface adhésive et dispositif pour détacher thermiquement une surface adhésive

(30) Priority: 25.04.2001 JP 2001128357
(43) Date of publication of application: 06.11.2002
(73) Proprietor: NITTO DENKO CORPORATION, Osaka (JP)
(72) Inventor: Izutani, Seiji, Ibaraki-shi, Osaka (JP); Kawanishi, Michirou, Ibaraki-shi, Osaka (JP); Arimitsu, Yukio, Ibaraki-shi, Osaka (JP)
(74) Representative: Grünecker, Kinkeldey, Stockmair & Schwanhäusser Anwaltssozietät

(56) References cited:
- EP-A- 0 884 766
- EP-A- 1 033 393

## Description

The present invention relates to a method of selectively releasing part of adherends by heating a thermally releasable pressure-sensitive adhesive sheet having a thermally expandable layer containing therein thermo-expandable microspheres, and an apparatus for thermally releasing an adherend to be used for the method.

Thermally releasable pressure-sensitive adhesive sheets having a thermally expandable layer containing therein thermo-expandable microspheres (for example, "Revalpha" and "Revaclean" (trade names) made by Nitto Denko Corporation) are being used in various fields for various uses. This pressure-sensitive adhesive sheet enables to adhere and fix a substance for conducting a desired processing and, after the processing, to release the adherend with ease by expanding the thermo-expandable microspheres in the thermally expandable layer through heating to decrease or vanish adhesion force.

With the above-described pressure-sensitive adhesive sheet, heating treatment is usually conducted, upon releasing the adherends from the sheet, all over the surface to which the substance is adhered to thereby release all of the adherends at a time. Recently, however, it has been increasingly demanded to release, upon thermal releasing, only one or some of a plurality of substances adhered to the pressure-sensitive adhesive sheet and hold the rest of the adherends in a state of being adhered to the sheet.

Specifically, for example, in a process of processing FPC (Flexible Printed Circuit) parts composed of a thin copper foil laminated with a polyimide film, there is included a step of heating the pressure-sensitive adhesive sheet, to which pieces of a substance having been cut in a state of being adhered and fixed to the pressure-sensitive adhesive sheet are adhered, to traverse and separate part of the cut pieces of the substance. In this step, it has been experienced that, by vibration caused upon the transverse and separation of part of the cut pieces, other remaining cut pieces suffer deformation or release. Also, in a step of dicing a semiconductor wafer or a laminated condenser, there have been involved a problem that, upon releasing parts after the dicing step by heating a pressure-sensitive adhesive sheet carrying the parts, the whole parts are undesirably released including those parts which are required to be adhered, and a problem that positional deviation (displacement) or release of the parts is caused due to vibration generated upon transverse and separation of the diced parts.

EP-A-1033393 describes a heat-peelable pressure-sensitive adhesive sheet wherein its adhesive force can be quickly lowered by heating. This property is achieved by incorporating into the heat-peelable pressure-sensitive adhesive sheet a heat expandable layer containing heat expandable microspheres and a non-heat expandable adhesive layer formed on at least one side thereof.

EP-A-0884766 deals with the removal of chips from a dicing tape. In this method, a shrink film is employed which shrinks upon heat treatment and enables that the chips can be easily picked up.

Therefore, an object of the invention is to provide a method of selectively releasing adherends, which enables, upon thermally releasing adherends from a thermally releasable pressure-sensitive adhesive sheet having a thermally expandable layer containing therein thermo-expandable microspheres by heating, to easily release only desired one or some of the adherends, with leaving other substances in a state of being adhered to the pressure-sensitive adhesive sheet, and an apparatus for thermally releasing the adhered subjects.

Another object of the invention is to provide a method of selectively releasing adherends, which enables, during processing of the adherends, to hold them on a thermally releasable pressure-sensitive adhesive sheet and, after the processing, to easily release only desired one or some of a plurality of the adherends without causing damages or positional deviation of the adherends, and an apparatus for thermally releasing the adherends.

As a result of intensive investigations to attain the above-described objects, the inventors have found that one or some of a plurality of substances adhered to a thermally releasable pressure-sensitive adhesive sheet can selectively be released by heating the pressure-sensitive adhesive sheet using a heating unit capable of partly heating the pressure-sensitive adhesive sheet, thus having completed the invention.

That is, the invention provides a method for thermally releasing an adherend (7a) or adherends (7a), which comprises selectively releasing one or some of a plurality of substances adhered on a thermally releasable pressure-sensitive adhesive sheet (5) having a thermally expandable layer (6) containing therein thermo-expandable microspheres, by heating the pressure-sensitive adhesive sheet (5) using a heating unit (8) capable of partly heating the pressure-sensitive adhesive sheet (5). In the above-described method, it is possible to selectively release the adherend (7) by heating the portion to which the substance intended to be released is adhered using a heating unit (8) having a heating portion (8a) of a shape in conformity with the shape of the adherend (7a) to be released. Also, in the above-described method, it is preferred to heat from at least one of the substance-adhered side and the opposite side thereto of the pressure-sensitive adhesive sheet (5).

The invention also provides a method for thermally releasing cut pieces of an adherend, which involves: a step of cutting a substance (7) adhered on a thermally releasable pressure-sensitive adhesive sheet (5) having a thermally expandable layer (6) containing therein thermo-expandable microspheres into a plurality of pieces; and a step of heating one or some of the plurality of cut pieces (7a) by a heating unit (8) adapted for partly heating the pressure-sensitive adhesive sheet (5) to thereby selectively release them.

The invention further provides an apparatus for thermally releasing an adherend (7a) or adherends (7a) from a thermally releasable pressure-sensitive adhesive sheet (5) having a thermally expandable layer (6) containing thermo-expandable microspheres, which has a fixing unit (9) for fixing the pressure-sensitive adhesive sheet (5) and a heating unit (8) for partly heating the pressure-sensitive adhesive sheet (5) to selectively release one or some of a plurality of the adherends (7a) from the pressure-sensitive adhesive sheet (5). In this heating apparatus, the heating unit (8) may have a heating portion (8a) of a shape in conformity with the shape of an adhered subject to be released (7a), and the heating unit (8) having such heating portion (8a) is preferably provided at least on one of the substance-adhered side and the opposite side thereto of the pressure-sensitive adhesive sheet (5). In this apparatus, the fixing unit (9) for fixing the pressure-sensitive adhesive sheet (5) and/or the heating unit (8) for partly heating the pressure-sensitive adhesive sheet (5) may be movable in a horizontal direction and/or a vertical direction.

The invention further provides an apparatus for thermally releasing cut pieces of an adherend (7a) from a thermally releasable pressure-sensitive adhesive sheet (5) having a thermally expandable layer (6) containing thermo-expandable microspheres, which has a fixing unit (9) for fixing the pressure-sensitive adhesive sheet (5); a cutting unit for cutting an adherend (7) adhered on the pressure-sensitive adhesive sheet (5); and a heating unit (8) for partly heating the pressure-sensitive adhesive sheet (5) to selectively release one or some of a plurality of the adherends (7a) from the pressure-sensitive adhesive sheet (5).

### Brief Description of the Invention

Fig. 1 is an outline cross-sectional view showing one example of the thermally releasable pressure-sensitive adhesive sheet (5) for use in the method of the invention.
Fig. 2 is an outline cross-sectional view showing one example of the method of the invention for thermally releasing an adherend and an apparatus of the invention for thermally releasing an adherend.
Fig. 3 is an outline cross-sectional view showing another example of the method of the invention for thermally releasing an adherend and an apparatus of the invention for thermally releasing an adherend.
Fig. 4 is an outline cross-sectional view showing a further example of the method of the invention for thermally releasing an adherend and an apparatus of the invention for thermally releasing an adherend.
The reference numerals or signs used in the drawings are as set forth below.
   1 base material (i.e., backing)
   2 rubbery organic elastic layer
   3 thermally expandable pressure-sensitive adhesive layer
   4 separator
   5 thermally releasable pressure-sensitive adhesive sheet
   6 thermally expandable pressure-sensitive adhesive layer
   6a non-expanded portion
   6b expanded portion
   7 adherend
   7a adherend to be released (diced piece)
   8 heating unit
   8a heating portion
   9 fixing unit
   10 base material (i.e., backing)
   11 suction nozzle
   12 adhesive layer for fixing to a pedestal
   13 pedestal

### Detailed Description of the Invention

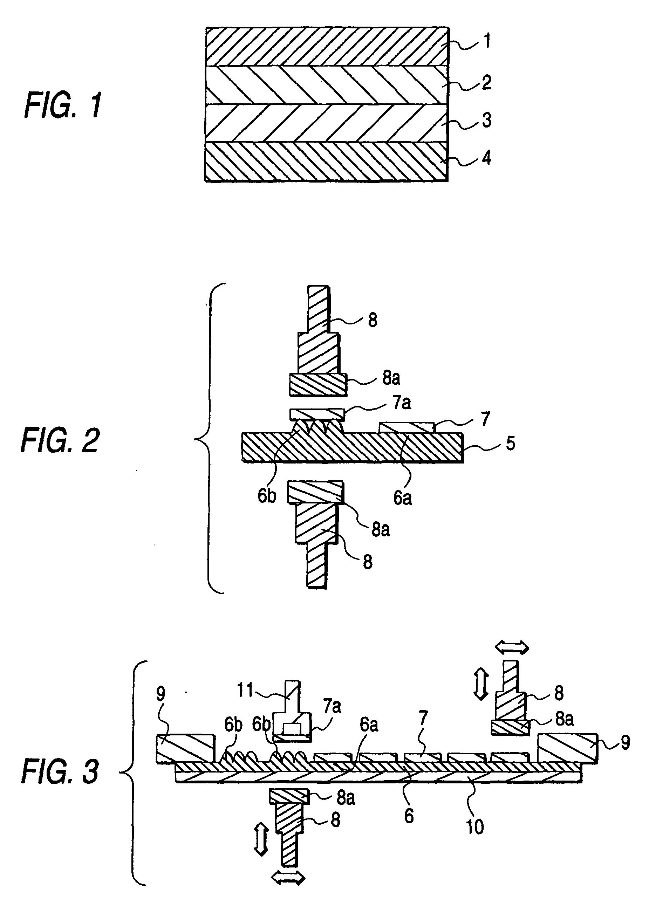

Amode for carrying out the invention is described in detail by reference to drawings as required. Fig. 1 is an outline cross-sectional view showing one example of a thermally releasable pressure-sensitive adhesive sheet to be used in the method of the invention. In the pressure-sensitive adhesive sheet shown in Fig. 1, a thermally expandable pressure-sensitive adhesive layer 3 is provided on one side of a supporting base material (backing) 1 via a rubbery organic elastic layer 2, and a separator 4 is further laminated thereon.

The base material (backing) 1 functions as a support, e.g., for the thermally expandable pressure-sensitive adhesive layer 3 and is generally a plastic film or sheet. However, proper thin materials such as paper, cloth, unwoven cloth or metal foil, or a laminate thereof and a plastic, or a laminate of plastic films (or sheets) may also be used. The thickness of the base material 1 is generally 500 um or less, preferably about 5 to about 250 um, though not limited to them. The surface of the base material 1 may have been subjected to a common surface treatment such as a treatment with chromic acid, an ozone exposure treatment, a flame exposure treatment, a high-voltage electric shock exposure treatment or an ionizating radiation treatment in order to enhance adhesion to an adjacent layer (in this case, the rubbery organic elastic layer 2) or may have been subjected to a release treatment.

The rubbery organic elastic layer 2 functions, upon adhering the pressure-sensitive adhesive sheet to a substance to be adhered thereto, to make the surface of the pressure-sensitive adhesive sheet well follow the surface shape of the substance to be adhered thereto and increase the area of adhesion and functions, upon thermally releasing the pressure-sensitive adhesive sheet from the adherend, to reduce restriction of foaming or expansion of the thermally expandable layer in the direction of the surface of pressure-sensitive adhesive sheet to help formation of a wave structure due to three-dimensional structural change of the thermally expandable layer.

In order to exhibit the above-described functions, the rubbery organic elastic layer 2 is formed preferably by, for example, a natural rubber, a synthetic rubber or a synthetic resin having some rubber elasticity, which has a D type Shore hardness based on ASTM D-2240 of 50 or less, preferably 40 or less.

As the synthetic rubber or the synthetic resin having some rubber elasticity, there are illustrated, for example, synthetic rubbers such as a nitrile-based rubber, a diene-based rubber and an acrylic-based rubber; and synthetic resins having some rubber elasticity such as ethylene-vinyl acetate copolymer, polyurethane, polybutadiene and soft polyvinyl chloride. Additionally, essentially hard polymers such as polyvinyl chloride can acquire some rubber elasticity when compounded with a component such as a plasticizer or a softening agent. Such compounded resins can also be used as a constituent of the rubbery organic elastic layer.

Also, the rubbery organic elastic layer 2 may be formed by conventional or known pressure-sensitive adhesives based on a rubbery material or a resin. As such pressure-sensitive adhesives, there are illustrated, for example, rubber-based pressure-sensitive adhesives, acrylic-based pressure-sensitive adhesives, styrene-conjugated diene block copolymer-based pressure-sensitive adhesives. In addition, pressure-sensitive adhesives having creep characteristics improved by compounding with a heat-meltable resin having a melting point of about 200 °C or lower may also be used. The pressure-sensitive adhesive may contain, in addition to a tacky component (base polymer), proper additives such as a cross-linking agent (for example, a polyurethane-based cross-linking agent or an alkyl etherified melamine-based cross-linking agent), a tackifier (for example, a rosin derivative resin, a polyterpene resin, a petroleum resin or an oil-soluble phenolic resin), a plasticizer, a filler, an aging inhibitor, etc.

As the pressure-sensitive adhesives, there may be used, more specifically, rubber-based pressure-sensitive adhesives containing a natural rubber or various synthetic rubbers as base polymer; and acrylic-based pressure-sensitive adhesives containing, as a base polymer, an acrylic-based polymer (homopolymer or copolymer) using one or more alkyl (meth)acrylates (e.g., esters containing C₁₋₂₀ alkyl moiety, such as methyl ester, ethyl ester, propyl ester, isopropyl ester, butyl ester, 2-ethylhexyl ester, iso-octyl ester, isononyl ester,isodecyl ester, dodecyl ester, tridecyl ester, pentadecyl ester, hexadecyl ester, heptadecyl ester, octadecyl ester, nonadecyl ester and eicosyl ester) as monomer components.

Additionally, the acrylic-based polymer may contain, as required, units corresponding to other monomer components copolymerizable with the alkyl (meth) acrylate for the purpose of improving cohesive force, heat resistance and cross-linking properties. As suchmonomer components, there are illustrated, for example, carboxyl group-containing monomers such as acrylic acid, methacrylic acid and itaconic acid; hydroxyl group-containing monomers such as hydroxyethyl (meth) acrylate and hydroxypropyl (meth) acrylate; (N-substituted)amide monomers such as N-methylol (meth)acrylamide; vinyl monomers such as vinyl acetate, styrene, α-methylstyrene and vinyl ether; cyanoacrylate monomers such as acrylonitrile and methacrylonitrile; epoxy group-containing acrylic monomers such as glycidyl (meth)acrylate; and olefinic monomers such as isoprene, butadiene and isobutylene. These monomer components may be used independently or in combination of two or more.

The thickness of the rubbery organic elastic layer 2 is generally from about 5 to about 300 µm, preferably from about 20 to about 150 µm. In case where the thickness of the rubbery organic elastic layer 2 is too thin, three-dimensional structural change can not be caused upon thermal expansion of the thermally expandable layer, thus releasing properties being liable to be deteriorated.

The rubbery organic elastic layer 2 may be formed by a proper method, for example, a method of coating on the base material 1 a coating solution containing elastic layer-forming materials such as the natural rubber, synthetic rubber or synthetic resin having rubber elasticity, an adhesive, etc. (coating method), a method of bonding a film composed of the elastic layer-forming materials or a laminated film previously preparedby forming a layer composed of the elastic layer-forming materials on one or more of the thermally expandable pressure-sensitive adhesive layer 3 to the base material 1 (dry lamination method), or a method of co-extruding a resin composition containing the constituents of the base material 1 and a resin composition containing the elastic layer-forming materials (co-extrusion method). The rubbery organic elastic layer 2 may be a single layer or may be constituted by two or more layers. Additionally, the rubbery organic elastic layer 2 may not necessarily be provided but, since it serves to enhance the ability of fixing an adherend upon processing and releasing properties after processing, it is preferred to provide the elastic layer 2.

The thermally expandable pressure-sensitive adhesive layer 3 contains a pressure-sensitive adhesive for imparting tackiness and contains thermo-expandable microspheres for imparting thermally expandable properties. Therefore, a substance to be processed is securely fixed upon being subjected to desired processing in a state of being adhered and fixed to the pressure-sensitive adhesive sheet, and thus processing can be conducted smoothly and, after the processing, the processed substance can easily be released from the pressure-sensitive adhesive sheet by heating the thermally expandable pressure-sensitive adhesive layer 3 to foam and/or expand the thermo-expandable microspheres whereby the contact area between the thermally expandable pressure-sensitive adhesive sheet 3 and the adherend is reduced, and adhesion therebetween is also reduced.

As the pressure-sensitive adhesive for forming the thermally expandable pressure-sensitive adhesive layer 3, there are used conventional or known pressure-sensitive adhesives containing as a base a rubbery material or a resin permitting the thermo-expandable microspheres to foam and/or expand upon heating, preferably those which restrict foaming and/or expansion of the thermo-expandable microspheres as little aspossible. As such pressure-sensitive adhesive, there are illustrated, for example, those pressure-sensitive adhesives which have been illustrated with respect to the rubbery organic elastic layer. Additionally, in the thermally expandable pressure-sensitive adhesive layer 3 for strongly adhering a substance (substance to be processed) before processing, those pressure-sensitive adhesives are more preferred, in view of balance in reduction of adhesion force between before and after the heating treatment, which contain as a base a polymer having a dynamic elastic modulus of 5,000 to 1,000,000 Pa at ordinary temperature to 150°C.

As the thermo-expandable microspheres, microbaloons each having encapsulated in its elastic shell a material capable of easily gasified to expand upon being heated such as isobutane, propane or pentane suffice. The shell is formed, in many cases, by a heat-meltable material or a material which can be broken by thermal expansion. As the material for forming the shell, there are illustrated, for example, vinylidene chloride-acrylonitrile copolymer, polyvinyl alcohol, polyvinyl butyral, polymethyl methacrylate, polyacrylonitrile, polyvinylidene chloride and polysulfone. The thermo-expandable microspheres can be produced in a conventional manner by, for example, a coacervation process or a interfacial polymerization process. Additionally, as the thermo-expandable microspheres, there are commercially availableones such as Microsphere (trade name; made by Matsumoto Yushi Seiyaku K.K.).

In order to effectively reduce adhesion force of the thermally expandable layer by the heating treatment, those thermo-expandable microspheres are preferred which have a suitable strength not to be burst till the volume of the microbaloon becomes 5 times or more, particularly 10 times or more, as much as that of the original microbaloon.

The amount of the thermo-expandable microspheres to be compounded can properly be decided depending upon the degree of expansion (foaming) of the thermally expandable pressure-sensitive adhesive layer 3 or the degree of reduction in adhesion force but, in general, it ranges from, for example, 1 to 150 parts by weight, preferably 25 to 100 parts by weight, per 100 parts by weight of a base polymer for forming the thermally expandable pressure-sensitive adhesive layer 3. The thermo-expandable microspheres are preferably classified to make the particle size of the microbaloons uniform before use.

The thickness of the thermally expandable pressure-sensitive adhesive layer 3 is, for example, 5 to 300 µm, preferably about 20 to about 150 µm. The thickness of the thermally expandable pressure-sensitive adhesive layer 3 is preferably more than the maximum particle size of the thermo-expandable microspheres contained therein. In case where the thickness of the thermally expandable pressure-sensitive adhesive layer 3 is too small, surface smoothness of the layer is spoiled due to unevenness formed by the thermo-expandable microspheres, and adhesion force before heating is liable to be decreased. On the other hand, in case where the thermally expandable pressure-sensitive adhesive layer is too thick, there might arise cohesive failure after expansion or foaming of the thermally expandable pressure-sensitive adhesive layer 3, leading to remaining of the adhesive on the released substance.

The thermally expandable pressure-sensitive adhesive layer 3 can be formed in a conventional manner by, for example, a method of preparing a coating solution containing a pressure-sensitive adhesive and thermo-expandable microspheres using, as needed, a solvent, followed by coating the solution on a rubbery organic elastic layer 2, or a method of coating the above-described coating solution on a suitable separator (release paper, or the like) to form a thermally expandable pressure-sensitive adhesive layer, followed by transferring it onto the rubbery organic elastic layer 2. The thermally expandable pressure-sensitive adhesive layer 3 may be a single layer or a plurality of layers.

As the separator 4, there may be used conventional release paper or the like. The separator 4 is used as a protective member for the thermally expandable pressure-sensitive adhesive layer 3, and is peeled off upon adhering the pressure-sensitive adhesive sheet to an adherend. The separator 4 may not necessarily be provided.

Additionally, the thermally expandable pressure-sensitive adhesive layer 3 may be formed not only on one side of the base material 1 but on both sides as well. Also, the rubbery organic elastic layer 2 may be provided either on one side or on both sides of the base material 1. Further, it is possible to provide the thermally expandable pressure-sensitive adhesive layer 3 (or, further, the rubbery organic elastic layer) on one side of the base material, and a common adhesive layer not containing the thermo-expandable microspheres on the other side. Additionally, an intermediate layer such as an undercoating layer or an adhesive layer may be provided between the base material 1 and the rubbery organic elastic layer 2 or between the rubbery organic elastic layer 2 and the thermally expandable pressure-sensitive adhesive layer 3.

In addition, the thermally expandable pressure-sensitive adhesive layer 3 may be divided into a thermally expandable layer containing thermo-expandable microspheres and a pressure-sensitive adhesive layer containing a pressure-sensitive adhesive.

Fig. 2 is an outline cross-sectional view showing one example of the method of the invention for thermally releasing an adherend and an apparatus of the invention for thermally releasing an adherend. In the thermally releasing method of the invention, one or some of a plurality of adherends adhered to a thermally releasable pressure-sensitive adhesive sheet are selectively released by partly heating the pressure-sensitive adhesive sheet.

In Fig. 2 is shown a step wherein a plurality of substances 7 are adhered to the thermally releasable pressure-sensitive adhesive sheet 5 fixed by a fixing unit, a heating unit 8 having a heating portion 8a of a shape in conformity with the shape of the adherend 7a to be released is provided, and the pressure-sensitive adhesive sheet is heated at the portion to which the adherend 7a to be released is adhered. As the thermally releasable pressure-sensitive adhesive sheet, the aforementioned ones may be used.

The adherend 7 is not particularly limited and may be any substance which is to be subjected to various processings in a state of being adhered and fixed to the pressure-sensitive adhesive sheet. Typical examples thereof include electronic parts having a silicon wafer as a substrate (board).

As the heating unit, any one may be used with no limitation that can sufficiently heat the thermally releasable pressure-sensitive adhesive sheet. For example, there may be employed an electrothermal heater; dielectric heating; magnetic heating; and heating with electromagnetic radiations such as infrared radiations (e.g., near-infrared radiation, middle-infrared radiation and far-infrared radiation). Heating may be conducted either directly or indirectly.

As a material for the heating portion 8a, a proper one may be selected depending upon the heating manner. In the case of, for example, using an electrothermal heater as the heating unit, the heating portion 8a may be constituted by both a material having a high thermal conductivity such as a metal and a heat insulator such as asbestos. In addition, in order to improve adhesion between the heating portion and the adherend, an elastic material such as rubber may be used in combination. When the heating portion 8a is constituted by a combination of an elastic material (heat conductive elastic material) such as rubber, a metal material and a heat insulator, the thermally releasable pressure-sensitive adhesive sheet can be expanded more rapidly, with the adherend being separated in a shorter time.

Shape and size of the heating portion 8a are properly designed depending upon the shape of the adherend 7a to be released. When the adhered portion is heated by using the heating portion 8a of a shape in conformity with the shape of the adherend 7a to be released, the pressure-sensitive adhesive sheet expands at the heatedportion (expanded portion 6b) from the state before heating (unexpanded portion 6a), and only one or some of a plurality of the adherends lose adhesion force, thus adherend 7a to be released being able to be selectively released.

As the heating unit 8, a heating unit having the heating portion 8a is used.

The time for heating by the heating unit 8 varies depending upon properties of the adherend 7 and the heating unit and can not be specified in a general manner. However, heating for a too long time would cause portions not intended to be released to be released as well due to conduction of heat from the heated pressure-sensitive adhesive sheet 5 and the adherend 7, thus care being required.

The thermally releasable pressure-sensitive adhesive sheet is fixed by a fixing unit. As a fixing system, there are no limitations as long as positional deviation is not caused between the adhered sheet and the pressure-sensitive adhesive sheet during processing or upon releasing. For example, there may be employed a fixing system using a ring frame, a fixing system using a pedestal and a fixing system utilizing vacuum suction.

In the above-described example, the pressure-sensitive adhesive sheet 5 is heated by using a heating portion of a shape in conformity with the shape of the adherend 7a to be released, and hence the adhered portion of the adherend 7a is selectively heated to cause the thermo-expandable microspheres in the thermally expandable layer to expand (expanded portion 6b), thus adhesion force being decreased or vanished so much that the adherend 7a adhered to the heated portion of the sheet 5 is released. On the other hand, the pressure-sensitive adhesive sheet is not heated at areas spaced from the heating unit 8, and hence it does not undergo a decrease in adhesion force due to expansion of the thermo-expandable microspheres (non-expanded portion 6a), thus the substance 7 adhered to the portion of the pressure-sensitive adhesive sheet 5 remains to be adhered to the sheet 5. Thus, according to the invention, it is possible to selectively release an adherend located at only a desired position among a plurality of adherends through a simple operation.

Additionally, the heating unit 8 can be provided on at least one of the side to which the adherend is adhered and the opposite side thereto of the pressure-sensitive adhesive sheet.

Fig 3. is an outline cross-sectional view showing another example of the method of the invention for thermally releasing an adherend and an apparatus for thermally releasing an adherend.

In Fig. 3 is shown a step wherein an adherend 7 adhered to a thermally releasable pressure-sensitive adhesive sheet constituted by a base material 10 and a thermally expandable pressure-sensitive adhesive layer 6 is cut into a plurality of pieces by a cutting unit, the pressure-sensitive adhesive sheet is partly heated by a heating unit 8 at a portion to which a cut piece 7a to be released is adhered among a plurality of the cut pieces, and the cut piece 7a is released and recovered by means of a suction nozzle 11. The pressure-sensitive adhesive sheet is fixed by adhering a fixing unit 9 to the pressure-sensitive adhesive layer constituting the pressure-sensitive adhesive sheet. In addition, the heating unit 8 is provided movably in the horizontal direction and/or the vertical direction.

As the base material 10 and the thermally expandable pressure-sensitive adhesive layer 6 constituting the thermally releasable pressure-sensitive adhesive sheet, those having heretofore been described may be used. Additionally, a rubbery organic elastic layer may be provided between the base material 10 and the thermally expandable pressure-sensitive adhesive layer 6.

As the cutting unit, a proper one may be selected depending upon the kind of the adherend 7. For example, in the case of using as the adherend an electronic part having a substrate of silicon wafer, it is possible to subject the part adhered to and fixed on the thermally releasable pressure-sensitive adhesive sheet to a cutting processing such as dicing processing.

As the heating unit 8, the aforesaid heating unit may be utilized.

As the fixing unit 9, a proper one maybe selected depending upon the fixing system. In the above-described example, there is employed a fixing system using a ring frame (fixing ring).

The heating portion 8a of the heating unit 8 is made in conformity with the shape of the cut piece 7a to be released. The heating unit 8 can be provided on at least one of the side to which the adherend is adhered and the opposite side thereto of the pressure-sensitive adhesive sheet.

In the above-described example, the thermally releasable pressure-sensitive adhesive sheet is fixed by the fixing unit 9, the adherend 7 adhered to the pressure-sensitive adhesive sheet is cut by a cutting unit, and the pressure-sensitive adhesive sheet is heated by using a heating portion 8a of a shape in conformity with the shape of the cut piece 7a to be released, and hence the adhered portion of the cut piece 7a is selectively heated to cause the thermo-expandable microspheres in the thermally expandable layer to expand (expanded portion 6b), thus adhesion force being decreased or vanished so much that the adherend 7a adhered to the heated portion of the pressure-sensitive adhesive sheet is released. On the other hand, the pressure-sensitive adhesive sheet is not heated at areas spaced from the heating unit 8, and hence it does not undergo a decrease in adhesion force due to expansion of the thermo-expandable microspheres (non-expanded portion 6a), thus the substance 7 adhered to the portion of the pressure-sensitive adhesive sheet remains to be adhered to the sheet. In addition, the heating portion 8a may be provided on the side to which the substance is adhered or on the opposite side thereto and, further, the heating portion 8a may be provided on both sides to shorten the heating time. Further, it is possible to three-dimensionally movably provide the heating portion 8a to selectively and effectively heat the pressure-sensitive adhesive sheet.

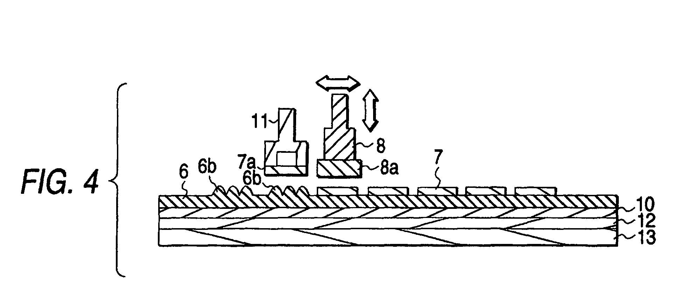

Fig 4. is an outline cross-sectional view showing other example of the method of the invention for thermally releasing an adherend and an apparatus for thermally releasing an adherend.

In Fig. 4 is shown a step wherein an adherend 7 adhered to a thermally releasable pressure-sensitive adhesive sheet constituted by a base material 10, a thermally expandable pressure-sensitive adhesive layer 6 and an adhesive layer 12 for fixing the sheet to a pedestal is cut into a plurality of pieces by a cutting unit, the pressure-sensitive adhesive sheet is partly heated by a heating unit 8 at a portion to which a cut piece 7a to be released is adhered among a plurality of the cut pieces, and the cut piece 7a is released and recovered by means of a suction nozzle 11. The pressure-sensitive adhesive sheet is fixed by adhering the adhesive layer 12 constituting the pressure-sensitive adhesive sheet for fixing to the pedestal to the pedestal 13. In addition, the heating unit 8 is provided movably in the horizontal direction and/or the vertical direction.

As the base material 10 and the thermally expandable pressure-sensitive adhesive layer 6 constituting the thermally releasable pressure-sensitive adhesive sheet, those having heretofore been described may be used. A rubbery organic elastic layer may be provided between the base material 10 and the thermally expandable pressure-sensitive adhesive layer 6. The adhesive layer 12 for fixing the sheet to the pedestal may be formed by using a conventional or known pressure-sensitive adhesive and, as the pressure-sensitive adhesive, those which have been illustrated with respect to the rubbery organic elastic layer may be used.

As the cutting unit, a proper one may be selected depending upon the kind of the adherend 7. For example, in the case of using as the adherend an electronic part having a substrate of silicon wafer, it is possible to subject the part adhered to and fixed on the thermally releasable pressure-sensitive adhesive sheet to a cutting processing such as dicing processing.

As the heating unit 8, the aforesaid heating unit may be utilized.

As the fixing unit, a fixing system using a pedestal is employed in this example. As a method for fixing to the pedestal, there may be employed a method of using a thermally releasable pressure-sensitive adhesive sheet having an adhesive layer for adhering to the pedestal on the opposite side to the thermally expandable pressure-sensitive adhesive layer with respect to the base material of the thermally releasable pressure-sensitive adhesive sheet, and fixing to the pedestal through the pressure-sensitive adhesive layer for fixing to the pedestal. In addition, as other fixing system, there may be employed a fixing system using vacuum suction. In this case, the pressure-sensitive adhesive layer for adhering to the pedestal is not necessary.

The heating portion 8a of the heating unit 8 is made in conformity with the shape of the cut piece 7a to be released. The heating unit 8 is provided only on the side to which the adherend is adhered.

In the above-described example, positional deviation can effectively be prevented during processing of the part by fixing the thermally releasable pressure-sensitive adhesive sheet to the pedestal and, after the processing, only desired substance can be released by selectively heating in the same manner as described above. In addition, in the case of fixing to the pedestal, the heating portion 8a can be provided only on the side to which the substance is adhered, and it is possible to three-dimensionally movably provide the heating portion 8a to selectively and effectively heat the pressure-sensitive adhesive sheet.

Therefore, according to the invention, it is possible to selectively release an adherend located at only a desired position among a plurality of adherends through a simple operation. Further, according to the method of the invention, a cutting step wherein a substance adhered to a pressure-sensitive adhesive sheet is cut into a plurality of pieces and a releasing step wherein one or some of a plurality of the cut pieces are selectively released by heating with a heating portion of a shape in conformity with the shape of the cut piece can be conducted continuously.

According to the method of the invention, it is possible, upon releasing adherends from a thermally releasable pressure-sensitive adhesive sheet having a thermally expandable layer containing therein thermo-expandable microspheres, to release only one or some of a plurality of the adherends with ease and a good accuracy, while the rest of the adherends remain adhered to the pressure-sensitive adhesive sheet.

According to the thermally releasing apparatus of the invention, adherends having a finer structure and a smaller thickness can be held without release during processing and, after the processing, only desired one or some of a plurality of the adherends can be released with ease and a good accuracy, thus such failure as deviation of parts being suppressed, and reduction in productivity or yield being prevented.

The invention is described in more detail by reference to Examples which, however, do not limit the invention in any way.

### Example 1

The following is an example utilizing the method of the invention for thermally releasing an adherend and an apparatus for thermally releasing an adherend as shown in Fig. 3.

A 150 mm x 150 mm Ni foil (100 µm thick) was adhered to a thermally expandable pressure-sensitive adhesive layer of a thermally releasable pressure-sensitive adhesive sheet (fixed by means of a fixing ring) constituted by a polyester base material (100 µm thick) and the thermally expandable pressure-sensitive adhesive layer which showed a reduced adhesion at 120 °C, followed by dicing the Ni foil into pieces 5 mm square. As a heating portion, a heating unit comprising a 5 mm x 5 mm x 2 mm (thick) metal plate (SUS304) and a heat-conductive rubber sheet (5 mm x 5 mm x 1 mm (thick)) provided at the tip of an electrothermal heater was prepared and heated using the electrothermal heater so that the temperature of the rubber sheet portion (at the tip thereof) reached 150 °C. Then, the heating unit the tip of which was heated to 150 °C was pressed against the sheet at the portion to which a Ni foil piece to be released was adhered among a plurality of the Ni foil pieces formed by the dicing to thereby thermally expand the thermally expandable pressure-sensitive adhesive layer. After adhesion force of the thermally expandable pressure-sensitive adhesive layer was reduced to almost zero, the Ni foil piece was released by a suction nozzle. Thereafter; an impact was forcibly applied to the rest of the Ni foil pieces still adhered on the pressure-sensitive adhesive tape at non-heated areas, but no release of the Ni foil pieces was found.

### Example 2

The following is an example utilizing the method of the invention for thermally releasing an adherend and an apparatus for thermally releasing an adherend as shown in Fig. 4.

A silicon wafer of 6 inches in diameter (150 µm thick) was adhered onto the thermally expandable pressure-sensitive adhesive layer of a thermally releasable pressure-sensitive adhesive sheet [trade name "Revalpha No. 3195"; made by Nitto Denko Corporation] with no air bubbles, and the adhesive side (the adhesive side for fixing to a pedestal) opposite to the wafer-adhered side of the pressure-sensitive adhesive sheet was adhered to a smooth, stainless steel-made pedestal, followed by dicing the wafer into 3-mm square pieces. As a heating portion, a heating unit comprising a 3 mm x 3 mm x 2 mm (thick) metal plate (SUS304) and a heat-conductive rubber sheet (3 mm x 3 mm x 1 mm (thick)) provided at the tip of an electrothermal heater was prepared and heated using the electrothermal heater so that the temperature of the rubber sheet portion (at the tip thereof) reached 120 °C. Then, the heating unit the tip of which was heated to 120 °C was pressed against the sheet at the portion to which a wafer piece to be released was adhered among a plurality of the wafer pieces formed by the dicing to thereby thermally expand the thermally expandable pressure-sensitive adhesive layer. After adhesion force of the thermally expandable pressure-sensitive adhesive layer was reduced to almost zero, the wafer piece was releasedby a suction nozzle. Thereafter, an impact was forcibly applied to the rest of the wafer pieces still adhered on the pressure-sensitive adhesive tape at non-heated areas, but no release of the wafer pieces was found.

### Comparative Example 1

In Example 1, heating was conducted all over the pressure-sensitive adhesive sheet to which a plurality of the Ni foil diced pieces were adhered, and Ni foil pieces to be released among the diced pieces were released by a suction nozzle. Thereafter, an impact was forcibly applied to the rest of the Ni foil pieces still adhered on the pressure-sensitive adhesive tape, and there was found release or positional deviation of the Ni foil diced pieces.

## Claims

1. A method for thermally releasing an adherend (7a), which comprises selectively releasing a plurality of adherends (7a) adhered on a thermally releasable pressure-sensitive adhesive sheet (5), the pressure-sensitive adhesive sheet (5) comprising a thermally expandable layer (6) containing thermo-expandable microspheres, by partly heating the pressure-sensitive adhesive sheet (5).

2. The method as described in claim 1, wherein the selective release is conducted by heating an adhered portion of the at least one adherend (7a) to be released, with a heating unit (8) having a heating portion (8a), in which the heating portion (8a) has a shape corresponding to that of the at least one adherend (7a) to be released.

3. The method as described in claim 1, wherein at least one of the adherend-adhered side and the opposite side thereto of the pressure-sensitive adhesive sheet (5) is subjected to the heating.

4. The method as described in claim 1, wherein the pressure-sensitive adhesive sheet (5) further comprises a rubbery organic elastic layer (2).

5. The method as described in claim 1, which comprises the steps of:
■ cutting the adherend (7) adhered to the thermally releasable pressure-sensitive adhesive sheet (5), into a plurality of cut pieces (7a); and
■ selectively releasing the cut pieces (7a) by partly heating the plurality of cut pieces (7a) with a heating unit (8) for partly heating the pressure-sensitive adhesive sheet (5).

6. The method as described in claim 5, wherein the pressure-sensitive adhesive sheet (5) further comprises a rubbery organic elastic layer (2).

7. An apparatus for thermally releasing part of a plurality of adherends (7a) from a thermally releasable pressure-sensitive adhesive sheet (5), the pressure-sensitive adhesive sheet (5) comprising a thermally expandable layer (6) containing thermo-expandable microspheres, which comprises:
■ a fixing unit (9) for fixing the pressure-sensitive adhesive sheet (5); and
■ a heating unit (8) for partly heating the pressure-sensitive adhesive sheet (5) to selectively release the plurality of the adherends (7a) from the pressure-sensitive adhesive sheet (5).

8. The apparatus as described in claim 7, wherein the heating unit (8) includes a heating portion (8a) having a shape in conformity with the shape of each of the adherends (7a) to be released.

9. The apparatus as described in claim 7, wherein the heating unit (8) including the heating portion (8a) is provided at least on one of an adherends-adhered side and an opposite side thereto of the pressure-sensitive adhesive sheet (5).

10. The apparatus as described in claim 7, wherein the fixing unit (9) for fixing the pressure-sensitive adhesive sheet (5) is movable in at least one of horizontal and vertical directions of the pressure-sensitive adhesive sheet (5).

11. The apparatus as described in claim 7, wherein the heating unit (8) for partly heating the pressure-sensitive adhesive sheet (5) is movable in at least one of horizontal and vertical directions of the pressure-sensitive adhesive sheet (5).

12. The apparatus as described in claim 7 for thermally releasing cut pieces of an adherend (7a), which comprises additionally;
a cutting unit for cutting an adherend (7) adhered on the pressure-sensitive sheet so as to form a plurality of cut pieces (7a).

## Patentansprüche

1. Verfahren zum thermischen Ablösen eines Adhärenden (7a), welches umfaßt: das selektive Ablösen einer Vielzahl von Adhärenden (7a), die an einer thermisch ablösbaren druckempfindlichen Klebefläche (5) angeklebt sind, worin die druckempfindliche Klebefläche (5) eine thermisch dehnbare Schicht (6) umfaßt, die thermo-dehnbare Mikrosphären enthält, durch teilweises Erhitzen der druckempfindlichen Klebefläche (5).

2. Verfahren wie in Anspruch 1 beschrieben, worin das selektive Ablösen durchgeführt wird durch Erhitzen eines angeklebten Teils des wenigstens einen abzulösenden Adhärenden (7a) mit einer Heiz-Einheit (8), die einen Heizabschnitt (8a) aufweist, worin der Heizabschnitt (8a) eine Form aufweist, die derjenigen des wenigstens einen abzulösenden Adhärenden (7a) entspricht.

3. Verfahren wie in Anspruch 1 beschrieben, worin wenigstens eine der Seiten an dem Adhärend festgeklebte Seite und derjenigen gegenüberliegende Seite der druckempfindlichen Klebefläche (5) einem Erhitzen unterworfen wird.

4. Verfahren wie in Anspruch 1 beschrieben, worin die druckempfindliche Klebefläche (5) darüber hinaus eine organische elastische kautschukartige Schicht (2) umfaßt.

5. Verfahren wie in Anspruch 1 beschrieben, welches die Schritte umfaßt, daß man:
- den Adhärend (7), der an der thermisch ablösbaren druckempfindlichen Klebefläche (5) festklebt, in eine Vielzahl von Schnittstücken (7a) schneidet; und
- die Schnittstücke (7a) durch teilweises Erhitzen der Vielzahl von Schnittstücken (7a) mit einer Heiz-Einheit (8) zum teilweisen Erhitzen der druckempfindlichen Klebefläche (5) selektiv ablöst.

6. Verfahren wie in Anspruch 5 beschrieben, worin die druckempfindliche Klebefläche (5) darüber hinaus eine organische elastische kautschukartige Schicht (2) umfaßt.

7. Vorrichtung zum thermischen Ablösen eines Teils einer Vielzahl von Adhärenden (7a) von einer thermisch ablösbaren druckempfindlichen Klebefläche (5), worin die druckempfindliche Klebefläche (5) eine thermisch dehnbare Schicht (6) umfaßt, die thermo-dehnbare Mikrosphären enthält, welche umfaßt:
- eine Fixier-Einheit (9) zum Fixieren der druckempfindlichen Klebefläche (5); und
- eine Heiz-Einheit (8) zum teilweisen Erhitzen der druckempfindlichen Klebefläche (5), um selektiv die Vielzahl der Adhärenden (7a) von der druckempfindlichen Klebefläche (5) abzulösen.

8. Vorrichtung wie in Anspruch 7 beschrieben, worin die Heiz-Einheit (8) einen Heizabschnitt (8a) einschließt, der eine Form aufweist, die in Übereinstimmung ist mit der Form jedes der abzulösenden Adhärenden (7a).

9. Vorrichtung wie in Anspruch 7 beschrieben, worin die Heiz-Einheit (8), die den Heizabschnitt (8a) einschließt, an wenigstens einer der Seiten an dem Adhärend festgeklebte Seite und derjenigen gegenüberliegende Seite der druckempfindlichen Klebefläche (5) vorgesehen ist.

10. Vorrichtung wie in Anspruch 7 beschrieben, worin die Fixier-Einheit (9) zum Fixieren der druckempfindlichen Klebefläche (5) in wenigstens einer der Richtungen horizontale und vertikale Richtung der druckempfindlichen Klebefläche (5) bewegbar ist.

11. Vorrichtung wie in Anspruch 7 beschrieben, worin die Heiz-Einheit (8) zum teilweisen Erhitzen der druckempfindlichen Klebefläche (5) in wenigstens einer der Richtungen horizontale Richtung und vertikale Richtung der druckempfindlichen Klebefläche (5) bewegbar ist.

12. Vorrichtung wie in Anspruch 7 beschrieben, zum thermischen Ablösen von Schnittstücken eines Adhärenden (7a), welche darüber hinaus umfaßt:
- eine Schneide-Einheit zum Schneiden eines Adhärenden (7), der an einer druckempfindlichen Fläche angeklebt ist, um eine Vielzahl von Schnittstücken (7a) zu bilden.

## Revendications

1. Procédé pour détacher thermiquement une surface adhésive (7a), qui comprend: détacher de manière sélective une pluralité de surfaces adhésives (7a) collées sur une feuille adhésive sensible à la pression (5) thermiquement détachable, la feuille adhésive sensible à la pression (5) comprenant une couche thermiquement extensible (6) contenant des microsphères thermo-extensibles, en chauffant partiellement la feuille adhésive sensible à la pression (5).

2. Procédé selon la revendication 1, dans lequel le détachement sélectif est effectué en chauffant une partie collée de la, au moins une, surface adhésive (7a) à détacher, avec une unité de chauffage (8) ayant une partie de chauffage (8a), dans laquelle la partie de chauffage (8a) a une forme correspondant à celle de la, au moins une, surface adhésive (7a) à détacher.

3. Procédé selon la revendication 1, dans lequel au moins l'un des côtés parmi le côté collé de la surface adhésive et le côté opposé à celui-ci de la feuille adhésive sensible à la pression (5) est soumis au chauffage.

4. Procédé selon la revendication 1, dans lequel la feuille adhésive sensible à la pression (5) comprend en outre une couche élastique organique caoutchouteuse (2).

5. Procédé selon la revendication 1, qui comprend les étapes consistant à :
- découper la surface adhésive (7) collée à la feuille adhésive sensible à la pression (5) thermiquement détachable, en une pluralité de pièces découpées (7a) ; et
- détacher de manière sélective les pièces découpées (7a) en chauffant partiellement la pluralité de pièces découpées (7a) avec une unité de chauffage (8) pour chauffer partiellement la feuille adhésive sensible à la pression (5).

6. Procédé selon la revendication 5, dans lequel la feuille adhésive sensible à la pression (5) comprend en outre une couche élastique organique caoutchouteuse (2).

7. Appareil pour détacher thermiquement une partie de la pluralité de surfaces adhésives (7a) d'une feuille adhésive sensible à la pression (5) thermiquement détachable, la feuille adhésive sensible à la pression (5) comprenant une couche thermiquement extensible (6) contenant des microsphères thermo-extensibles, qui comprend :
- une unité de fixation (9) destinée à fixer la feuille adhésive sensible à la pression (5) ; et
- une unité de chauffage (8) destinée à chauffer partiellement la feuille adhésive sensible à la pression (5) pour détacher de manière sélective la pluralité de surfaces adhésives (7a) de la feuille adhésive sensible à la pression (5).

8. Appareil selon la revendication 7, dans lequel l'unité de chauffage (8) comprend une partie de chauffage (8a) ayant une forme conforme à la forme de chacune des surfaces adhésives (7a) à détacher.

9. Appareil selon la revendication 7, dans lequel l'unité de chauffage (8) comprenant la partie de chauffage (8a) est disposée au moins sur l'un des côtés parmi un côté collé des surfaces adhésives et un côté opposé à celui-ci de la feuille adhésive sensible à la pression (5).

10. Appareil selon la revendication 7, dans lequel l'unité de fixation (9) destinée à fixer la feuille adhésive sensible à la pression (5) est mobile dans au moins l'une des directions horizontale et verticale de la feuille adhésive sensible à la pression (5).

11. Appareil selon la revendication 7, dans lequel l'unité de chauffage (8) destinée à chauffer partiellement la feuille adhésive sensible à la pression (5) est mobile dans au moins l'une des directions horizontale et verticale de la feuille adhésive sensible à la pression (5).

12. Appareil selon la revendication 7 destiné à détacher thermiquement des pièces découpées d'une surface adhésive (7a), qui comprend en plus :
- une unité de découpage destinée à découper une surface adhésive (7) collée sur la feuille adhésive sensible à la pression de façon à former une pluralité de pièces découpées (7a).
